# EUROPEAN PATENT SPECIFICATION

(11) **EP 3 605 658 B1**
(45) Date of publication and mention of the grant of the patent: **15.01.2025**
(21) Application number: 19174680.9
(22) Date of filing: 15.05.2019
(51) Int. Cl.: G06F 30/23, H01M 50/503, H01M 50/505, H01M 50/522

(54) **METHOD AND APPARATUS FOR DESIGNING FLEXIBLE COPPER BUSBAR OF POWER BATTERY**
VERFAHREN UND VORRICHTUNG ZUM ENTWERFEN EINER FLEXIBLEN KUPFERSAMMELSCHIENE EINER LEISTUNGSBATTERIE
PROCÉDÉ ET APPAREIL DE CONCEPTION DE BARRE COLLECTRICE FLEXIBLE EN CUIVRE DE BATTERIE D'ALIMENTATION

(30) Priority: 02.08.2018 CN 201810871078
(43) Date of publication of application: 05.02.2020
(73) Proprietor: Saic Motor Corporation Limited, Shanghai 200120 (CN)
(72) Inventor: Zhou, Zhipeng, Shanghai (CN); Xu, Xiyong, Shanghai (CN); Wang, Jing, Shanghai (CN); Xu, Xinan, Shanghai (CN); Fan, Hui, Shanghai (CN)
(74) Representative: HGF

(56) References cited:
- EP-A2- 2 876 705
- CN-A- 107 423 499
- US-A1- 2018 097 322

## Description

### Technical Field

The invention relates to the field of power battery, and in particular relates to a method and apparatus for designing a flexible copper busbar of a power battery.

### Background Art

A power battery is formed by connecting a plurality of battery modules in series. Property of the power battery is directly affected by the design of electric connection structures between battery modules. Thus, strict requirements are imposed on reliability, electric current carrying capacity and contact resistance between battery modules. Currently, thanks for their advantages like easy manufacturing, high current carrying capacity and convenient assembling ability, flexible copper busbars have become one of the most popular electric connection structures between battery modules.

In the designing of a flexible copper busbar, reliability requirement on it should be considered. A common practice comprises CAE (computer aided engineering) analysis to the flexible copper busbar. CAE analysis generally comprises to analyze whether the stress in the flexible copper busbar exceeds a predetermined value in working conditions, such as when the power battery is subjected to vibration or shock. However, CAE modeling faces a big difficulty since the flexible copper busbar is formed by laminating multi layers of thin sheet copper. Moreover, existing flexible copper busbar has a flat plate structure so the flexible copper busbar is easy to be stretched in harsh working conditions, which may further result in decreasing in fatigue life of the flexible copper busbar and changing in contact resistance.

US 2018/097322 A1 discloses a flexible bus bar having at least three rigid sections and at least two flexible sections.

CN 107423499 A discloses a system for improving anti-vibration performance of a battery pack.

### Summary of the Invention

In view of these, the invention provides a method and apparatus for designing a flexible copper busbar of a power battery, with an object of increasing the power battery designing efficiency and ensuring that there is no force transmission in the flexible copper busbar in harsh working conditions so that fatigue life of the flexible copper busbar and stability of contact resistance can be increased.

For achieving the above object, technical solutions are proposed below.

A method for designing a flexible copper busbar of a power battery, the flexible copper busbar comprising a first connection portion (11), a second connection portion (12), and a convex portion (13) connected between the first connection portion (11) and the second connection portion (12); wherein the first connection portion (11) comprises a first connection hole, and the first connection portion is connected with the first battery module via the first connection hole; and wherein the second connection portion (12) comprises a second connection hole, and the second connection portion is connected with the second battery module via the second connection hole, the first battery module and the second battery module being adjacent to each other;
the method being characterized in comprising:
performing mode analysis to a previously established finite element grid model of the power battery to find a direction with a minimum rigidity in the finite element grid model of the power battery, the finite element grid model of the power battery being a finite element model in which real structures of a battery pack casing, battery modules, a high voltage box and a BMS (BATTERY MANAGEMENT SYSTEM) are reflected, and both the mass of the flexible copper busbar and the mass of a harness of the power battery being added into the battery module;
obtaining a signal of an extreme mechanical shock working condition, the signal of the extreme mechanical shock working condition corresponding to data presented when a maximum space is created between the first battery module and the second battery module;
applying the signal of the extreme mechanical shock working condition in the direction with the minimum rigidity in the finite element grid model of the power battery to perform mechanical shock analysis in which the maximum space between the first battery module and the second battery module is obtained; and
obtaining the total length of the flexible copper busbar by, first, subtracting an initial space between the first battery module and the second battery module from the maximum space, then, multiplying the result thus obtained by a predetermined safety factor, and then, adding an initial space between opposite ends of the flexible copper busbar to the result that has been multiplied with the safety factor, the value of the safety factor being selected from a range of 1 to 3.

Optionally, the safety factor is 2.

An apparatus for designing a flexible copper busbar of a power battery, the flexible copper busbar comprising a first connection portion (11), a second connection portion (12), and a convex portion (13) connected between the first connection portion (11) and the second connection portion (12); wherein the first connection portion (11) comprises a first connection hole, and the first connection portion is connected with the first battery module via the first connection hole; and wherein the second connection portion (12) comprises a second connection hole, and the second connection portion is connected with the second battery module via the second connection hole, the first battery module and the second battery module being adjacent to each other;
the apparatus being characterized in comprising:
a mode analysis unit configured to perform mode analysis to a previously established finite element grid model of the power battery to find a direction with a minimum rigidity in the finite element grid model of the power battery, the finite element grid model of the power battery being a finite element model in which real structures of a battery pack casing, battery modules, a high voltage box and a BMS are reflected, and both the mass of the flexible copper busbar and the mass of a harness of the power battery being added into the battery module;
a data acquiring unit configured to obtain a signal of an extreme mechanical shock working condition, the signal of the extreme mechanical shock working condition corresponding to data presented when a maximum space is created between the first battery module and the second battery module;
a mechanical shock analysis unit configured to apply the signal of the extreme mechanical shock working condition in the direction with the minimum rigidity in the finite element grid model of the power battery to perform mechanical shock analysis in which the maximum space between the first battery module and the second battery module is obtained; and
a total length calculating unit configured to subtract an initial space between the first battery module and the second battery module from the maximum space, to multiply the result thus obtained by a predetermined safety factor, and then to add an initial space between opposite ends of the flexible copper busbar to the result that has been multiplied with the safety factor so that the total length of the flexible copper busbar is obtained, the value of the safety factor being selected from a range of 1 to 3.

Optionally, the safety factor is 2.

The technical solution of the invention can provide advantages listed below compared with prior art.

The above technical solutions provide a flexible copper busbar which comprises a first connection portion (11), a second connection portion (12), and a convex portion (13) connected between the first connection portion (11) and the second connection portion (12). In harsh working conditions, the convex portion (13) is stretched to become straightened under a force to become straightened, stress is distributed uniformly without stress concentration, and there is no force transmission. Fatigue life and contact resistance stability of the flexible copper busbar can be increased.

The above technical solutions provide a method and apparatus for designing the above flexible copper busbar, in which, by analyzing the maximum space between first and second battery modules which are connected with opposite ends of the flexible copper busbar and then determining the total length of the flexible copper busbar, a procedure of investigating the stress by modeling the flexible copper busbar is avoided, and power battery designing efficiency can be increased.

### Brief Description of the Drawings

For more clearly describing the technical solutions of embodiments of the invention or of prior art, drawings to be used in describing the embodiments or the prior art will be briefly introduced now. Obviously, the drawings described below only reflect some embodiments of the invention, and those skilled in the art can obtain other drawings based on the drawings provided here without doing inventive work.
Figure 1 is a schematic view of the structure of a flexible copper busbar designed according to an embodiment of the invention;
Figure 2 is a schematic view of the structure of another flexible copper busbar designed according to an embodiment of the invention;
Figure 3 is a schematic view of the structure of another flexible copper busbar designed according to an embodiment of the invention;
Figure 4 is a schematic view of the structure of another flexible copper busbar designed according to an embodiment of the invention;
Figure 5 is a schematic view of the structure of another flexible copper busbar designed according to an embodiment of the invention;
Figure 6 is a flowchart of a method for designing a flexible copper busbar provided in an embodiment of the invention;
Figure 7 is a schematic logic block view of an apparatus for designing a flexible copper busbar provided in an embodiment of the invention.

### Detailed Description of Preferred Embodiments

Now technical solutions in some embodiments of the invention will be clearly and fully described with reference to the drawings which show the embodiments of the invention.

Obviously, the described embodiments are only a portion of the embodiments of the invention, not all the embodiments. All other embodiments obtained by those skilled in the art based on the embodiments of the invention described here without doing inventive work fall in the scope of protection of the invention.

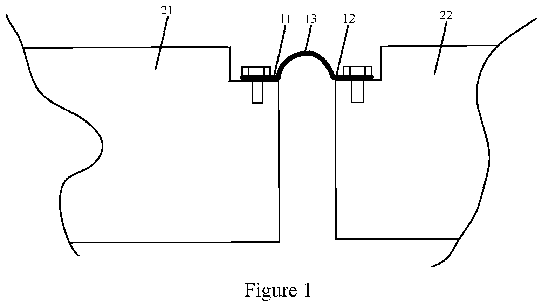

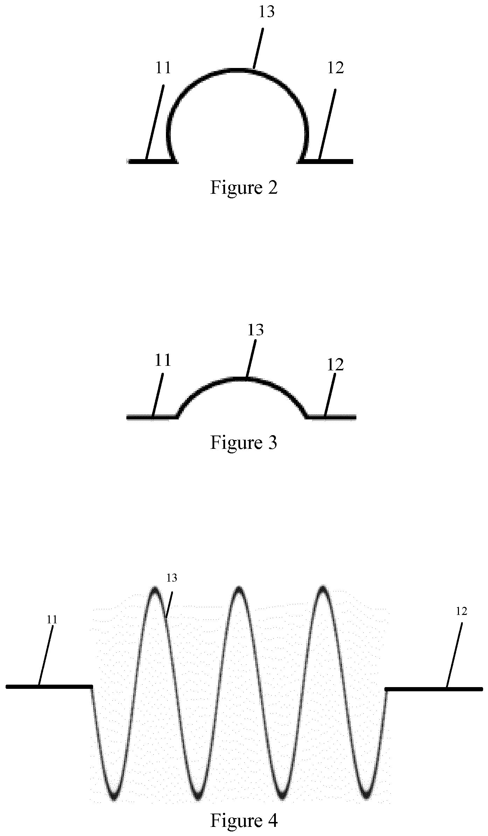

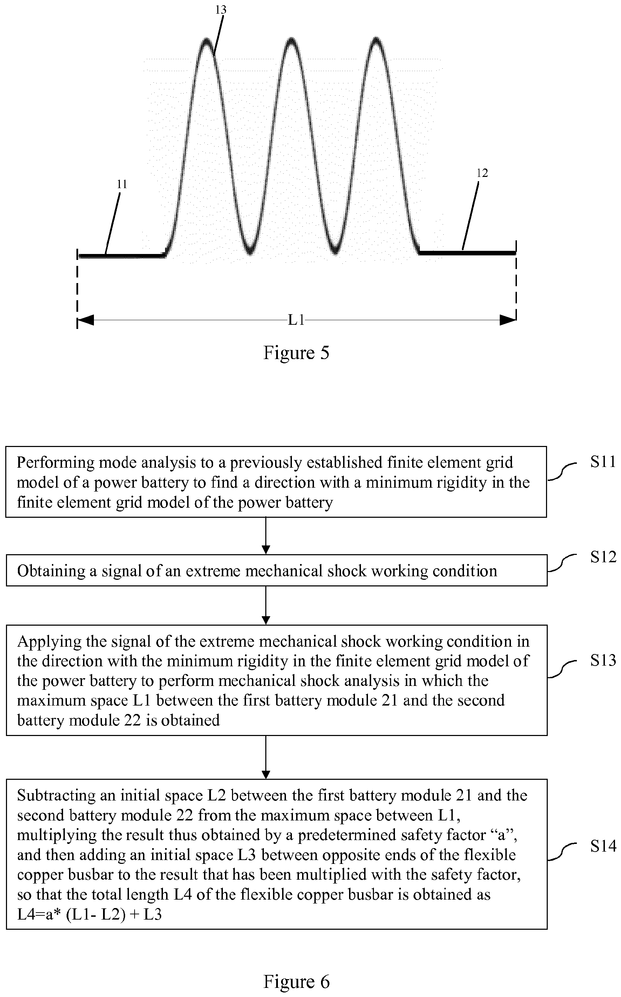

An example of a flexible copper busbar is illustrated in Figure 1. The structure of the flexible copper busbar comprises: a first connection portion 11, a second connection portion 12, and a convex portion 13 connected between the first connection portion 11 and the second connection portion 12. The convex portion 13 shown in the present example particularly has a shape of a semi-circle. The convex portion 13 may alternatively have a shape of other types of arc, such as that shown in Figure 2 and Figure 3, or have a shape of waves, such as that shown in Figure 4 and Figure 5.

The first connection portion 11 comprises a first connection hole and is connected to a first battery module 21 via the first connection hole.

The second connection portion 12 comprises a second connection hole and is connected to the second battery module 22 via the second connection hole, the first battery module 21 and the second battery module 22 being adjacent to each other.

By configuring the connection portion between the first connection portion 11 and the second connection portion 12 as the convex portion 13, the convex portion 13 is stretched to become straightened under a force in harsh working conditions, stress is distributed uniformly without stress concentration, and there is no force transmission. Fatigue life and contact resistance stability of the flexible copper busbar can be increased.

An embodiment provides a method for designing the above described flexible copper busbar. As illustrated in Figure 6, the method comprises the steps described below.

S 11: performing mode analysis to a previously established finite element grid model of a power battery to find a direction with a minimum rigidity in the finite element grid model of the power battery.

In the present embodiment, a finite element grid model of the power battery is previously defined in "Hypermesh" based on a three-dimensional model of the power battery. The finite element grid model of the power battery is a finite element model which reflects real structures of a battery pack casing, a battery module, a high voltage box and a BMS, both the mass of the flexible copper busbar and the mass of the harness being added into the battery module. That is to say, in the finite element grid model of the power battery, the structures of the harness and the flexible copper busbar are omitted so that modeling analysis to the flexible copper busbar is avoided, and the masses of the harness and the flexible copper busbar are given to the battery module so that the result of the analysis is more approximate to the real condition. In the finite element grid model of the power battery, the mass of the battery module equals to the real total mass of the battery module, the harness and the flexible copper busbar; the structure of the battery module has undergone simplification treatment, and the simplified battery module model comprises a simplified integer of end plates, side plates and all battery cells. For glued connections in the battery pack, "tie" treatment is used in the finite element grid model of the power battery; for bolted or welded connections in the battery pack, "rigid unit connection" is used in the finite element grid model of the power battery; for the welded connections in the battery pack, "seam" treatment may alternatively be used in the finite element grid model of the power battery.

Mode analysis to the finite element grid model of the power battery is performed by using a finite element structure analysis software, such as "optistruct", with full restrains being applied to the mounting point of the power battery, the mode analysis frequency being in the range of 0-200 Hz, and participation factors and effective masses in the directions of 6 DOFs (degrees of freedom) being output. As shown in Figure 6, the power battery is mounted to a vehicle, the driving direction is X-direction, the height direction is Z-direction, and the transverse direction of the vehicle is Y-direction. Basic frequencies in all the directions are determined based on results of the mode analysis. Specifically, it is found by means of analysis that the effective mass in Z-direction reaches its maximum level at 20 Hz, so the basic frequency in Z-direction is 20 Hz; it is found by means of analysis that the effective mass in Y-direction reaches its maximum level at 30 Hz, so the basic frequency in Y-direction is 30 Hz; it is found by means of analysis that the effective mass in X-direction reaches its maximum level at 40 Hz, so the basic frequency in X-direction is 40 Hz. Since Z-direction has a lowest basic frequency, the power battery is considered to have a weakest rigidity in Z-direction, that is, the direction with a minimum rigidity in the finite element grid model of the power battery is Z-direction.

S12: obtaining a signal of an extreme mechanical shock working condition.

The signal of the extreme mechanical shock working condition corresponds to data presented when a maximum space is created between the first battery module 21 and the second battery module 22. In the present embodiment, the signal of the extreme mechanical shock working condition is an acceleration of (25 g, 15 ms). "25 g" means 25 times of the acceleration of gravity, "15 ms" represents a half-chord wave having a pulse width of 15 ms.

S13: applying the signal of the extreme mechanical shock working condition in the direction with the minimum rigidity in the finite element grid model of the power battery to perform mechanical shock analysis in which the maximum space L1 between the first battery module 21 and the second battery module 22 is obtained.

In the mechanical shock analysis of the present embodiment, a finite element analysis software, such as "ls-dyna", is used; at the mounting point of the power battery, DOFs in all 5 directions except Z-direction are restrained; the signal of (25g, 15ms) is applied in Z-direction to the mounting point of the power battery, and corresponding relation of the space between the first battery module 21 and the second battery module 22 vs. time is obtained; and then the maximum space L1 between first battery module 21 and second battery module 22 can be obtained. Existing mode analysis methods and mechanical shock analysis methods can all be used in the present embodiment, and the invention imposes no limitation to concrete mode analysis procedures and mechanical shock analysis procedures.

S 14: subtracting an initial space L2 between the first battery module 21 and the second battery module 22 from the maximum space between L1, multiplying the result thus obtained by a predetermined safety factor "a", and then adding an initial space between L3 between opposite ends of the flexible copper busbar to the result that has been multiplied with the safety factor, so that the total length L4 of the flexible copper busbar is obtained as L4=a* (L1- L2) + L3.

The total length L4 is the distance between the opposite ends of the flexible copper busbar in the condition that the flexible copper busbar is under a pulling force and the convex portion 13 is stretched to become straightened. L3 is the distance between the opposite ends of the flexible copper busbar in the condition that the flexible copper busbar is free of any pulling force. The value of the safety factor is selected from a range of [1, 3]. In a particular embodiment, the safety factor is selected to be 2, as a result of which, fatigue life and contact resistance stability of the flexible copper busbar can be increased on one hand, and there is little material waste on the other hand.

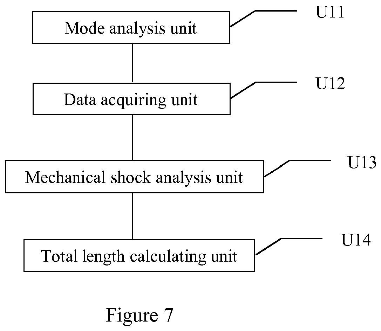

An embodiment further provides an apparatus for designing the above described flexible copper busbar. As shown in Figure 7, the apparatus comprises: a mode analysis unit U11, a data acquiring unit U12, a mechanical shock analysis unit U13 and a total length calculating unit U14.

The mode analysis unit U11 is configured to perform mode analysis to a previously established finite element grid model of a power battery to find a direction with a minimum rigidity in the finite element grid model of the power battery, the finite element grid model of the power battery being a finite element model in which real structures of a battery pack casing, battery modules, a high voltage box and a BMS are reflected, and the mass of the flexible copper busbar and the mass of the harness being added to the battery module. The data acquiring unit U12 is configured to obtain a signal of an extreme mechanical shock working condition, the signal of the extreme mechanical shock working condition corresponding to data presented when a maximum space is created between the first battery module and the second battery module.

The mechanical shock analysis unit U13 is configured to apply the signal of the extreme mechanical shock working condition in the direction with the minimum rigidity in the finite element grid model of the power battery to perform mechanical shock analysis in which the maximum space between the first battery module and the second battery module is obtained. The total length calculating unit U14 is configured to subtract an initial space between the first battery module and the second battery module from the maximum space, to multiply the result thus obtained by a predetermined safety factor, and then to add an initial space between opposite ends of the flexible copper busbar to the result that has been multiplied with the safety factor so that the total length of the flexible copper busbar is obtained, the value of the safety factor being selected from a range of [1, 3].

For the apparatus embodiment, considering that it corresponds substantially to the method embodiment, the features of the apparatus can be understood with reference to the description portion made to the method embodiment. The apparatus embodiment described above is only illustrative, in which units described as individual elements may be either physically separated from each other or not, and components shown as a unit may either form a physical unit or not, that is to say, these components may be arranged at one location or distributed into a plurality of network units. For achieving the object of the technical solutions of the present embodiments, some or all the modules of the units can be selected to be used according to real requirements. This can be appreciated and implemented by those skilled in the art without doing inventive work.

In the context, terms reflecting relations, like "first" and "second", are only used for distinguishing one integer or operation from another integer or operation, without requiring or suggesting that there are real relations or sequences among these integers or operations. Further, the term "comprise", "include" or their variants means non-exclusively comprising so that a procedure, method, article or apparatus defined as comprising a series of elements not only comprise the listed elements, but also comprise other elements that are not clearly listed here as well as inherent elements of the procedure, method, article or apparatus. Unless there is further restriction, an element defined by "comprises a..." does not exclude the condition that other similar elements exist in the procedure, method, article or apparatus that comprises this element.

In the description, various embodiments are described in a progressive manner, so only differences of an embodiment from other embodiments are described in details while the same or similar features of the embodiments can be understood with reference to the description to them in other embodiments.

Embodiments disclosed in the invention are described above so that those skilled in the art can implement or use the invention. Various modifications to these embodiments are obvious to those skilled in the art, and the general principle defined here can be implemented in other embodiments without departing from the scope of the invention as defined by the claims.

## Claims

1. A method for designing a flexible copper busbar of a power battery, the flexible copper busbar comprising a first connection portion (11), a second connection portion (12), and a convex portion (13) connected between the first connection portion (11) and the second connection portion (12); wherein the first connection portion (11) comprises a first connection hole, and the first connection portion is connected with the first battery module via the first connection hole; and wherein the second connection portion (12) comprises a second connection hole, and the second connection portion is connected with the second battery module via the second connection hole, the first battery module and the second battery module being adjacent to each other;
the method being **characterized in** comprising:
performing mode analysis to a previously established finite element grid model of the power battery to find a direction with a minimum rigidity in the finite element grid model of the power battery, the finite element grid model of the power battery being a finite element model in which real structures of a battery pack casing, battery modules, a high voltage box and a BMS are reflected, and both the mass of the flexible copper busbar and the mass of a harness of the power battery being added into the battery module;
obtaining a signal of an extreme mechanical shock working condition, the signal of the extreme mechanical shock working condition corresponding to data presented when a maximum space is created between the first battery module and the second battery module;
applying the signal of the extreme mechanical shock working condition in the direction with the minimum rigidity in the finite element grid model of the power battery to perform mechanical shock analysis in which the maximum space between the first battery module and the second battery module is obtained; and
obtaining the total length of the flexible copper busbar by, first, subtracting an initial space between the first battery module and the second battery module from the maximum space, then, multiplying the result thus obtained by a predetermined safety factor, and then, adding an initial space between opposite ends of the flexible copper busbar to the result that has been multiplied with the safety factor, the value of the safety factor being selected from a range of 1 to 3.

2. The method of claim 1, **characterized in that** the safety factor is 2.

3. An apparatus for designing a flexible copper busbar of a power battery, the flexible copper busbar comprising a first connection portion (11), a second connection portion (12), and a convex portion (13) connected between the first connection portion (11) and the second connection portion (12); wherein the first connection portion (11) comprises a first connection hole, and the first connection portion is connected with the first battery module via the first connection hole; and wherein the second connection portion (12) comprises a second connection hole, and the second connection portion is connected with the second battery module via the second connection hole, the first battery module and the second battery module being adjacent to each other;
the apparatus being **characterized in** comprising:
a mode analysis unit configured to perform mode analysis to a previously established finite element grid model of the power battery to find a direction with a minimum rigidity in the finite element grid model of the power battery, the finite element grid model of the power battery being a finite element model in which real structures of a battery pack casing, battery modules, a high voltage box and a BMS are reflected, and both the mass of the flexible copper busbar and the mass of a harness of the power battery being added into the battery module;
a data acquiring unit configured to obtain a signal of an extreme mechanical shock working condition, the signal of the extreme mechanical shock working condition corresponding to data presented when a maximum space is created between the first battery module and the second battery module;
a mechanical shock analysis unit configured to apply the signal of the extreme mechanical shock working condition in the direction with the minimum rigidity in the finite element grid model of the power battery to perform mechanical shock analysis in which the maximum space between the first battery module and the second battery module is obtained; and
a total length calculating unit configured to subtract an initial space between the first battery module and the second battery module from the maximum space, to multiply the result thus obtained by a predetermined safety factor, and then to add an initial space between opposite ends of the flexible copper busbar to the result that has been multiplied with the safety factor so that the total length of the flexible copper busbar is obtained, the value of the safety factor being selected from a range of 1 to 3.

4. The apparatus of claim 3, **characterized in that** the safety factor is 2.

## Patentansprüche

1. Verfahren zum Entwerfen einer flexiblen Kupfersammelschiene einer Leistungsbatterie, wobei die flexible Kupfersammelschiene einen ersten Verbindungsabschnitt (11), einen zweiten Verbindungsabschnitt (12) und einen konvexen Abschnitt (13) umfasst, der zwischen dem ersten Verbindungsabschnitt (11) und dem zweiten Verbindungsabschnitt (12) angeschlossen ist; wobei der erste Verbindungsabschnitt (11) ein erstes Verbindungsloch umfasst und der erste Verbindungsabschnitt über das erste Verbindungsloch mit dem ersten Batteriemodul verbunden ist; und wobei der zweite Verbindungsabschnitt (12) ein zweites Verbindungsloch umfasst und der zweite Verbindungsabschnitt über das zweite Verbindungsloch mit dem zweiten Batteriemodul verbunden ist, wobei das erste Batteriemodul und das zweite Batteriemodul nebeneinander liegen;
wobei das Verfahren **dadurch gekennzeichnet ist, dass** es umfasst:
Durchführen einer Modusanalyse an einem zuvor hergestellten Finite-Elemente-Gittermodell der Leistungsbatterie, um eine Richtung mit minimaler Steifigkeit im Finite-Elemente-Gittermodell der Leistungsbatterie zu finden, wobei das Finite-Elemente-Gittermodell der Leistungsbatterie ein Finite-Elemente-Modell ist, in dem reale Strukturen von einem Batteriepackgehäuse, Batteriemodulen, einer Hochspannungsbox und eines BMS widergespiegelt sind und sowohl die Masse der flexiblen Kupfersammelschiene als auch die Masse eines Kabelbaums der Leistungsbatterie in das Batteriemodul hinzugefügt werden;
Erhalten eines Signals eines Betriebszustands mit extremen mechanischen Stößen, wobei das Signal des Betriebszustands mit extremen mechanischen Stößen Daten entspricht, die vorliegen, wenn zwischen dem ersten Batteriemodul und dem zweiten Batteriemodul ein maximaler Abstand geschaffen wird;
Anwenden des Signals des Betriebszustands mit extremen mechanischen Stößen in der Richtung mit der minimalen Steifigkeit im Finite-Elemente-Gittermodell der Leistungsbatterie, um eine Analyse mechanischer Stöße durchzuführen, bei der der maximale Abstand zwischen dem ersten Batteriemodul und dem zweiten Batteriemodul erhalten wird; und
Erhalten der Gesamtlänge der flexiblen Kupfersammelschiene, indem zunächst ein Anfangsabstand zwischen dem ersten Batteriemodul und dem zweiten Batteriemodul vom maximalen Abstand abgezogen wird, dann das so erhaltene Ergebnis mit einem vorgegebenen Sicherheitsfaktor multipliziert wird und dann ein Anfangsabstand zwischen den gegenüberliegenden Enden der flexiblen Kupfersammelschiene zu dem mit dem Sicherheitsfaktor multiplizierten Ergebnis addiert wird, wobei der Wert des Sicherheitsfaktors aus einem Bereich von 1 bis 3 ausgewählt wird.

2. Verfahren nach Anspruch 1, **dadurch gekennzeichnet, dass** der Sicherheitsfaktor 2 beträgt.

3. Vorrichtung zum Entwerfen einer flexiblen Kupfersammelschiene einer Leistungsbatterie, wobei die flexible Kupfersammelschiene einen ersten Verbindungsabschnitt (11), einen zweiten Verbindungsabschnitt (12) und einen konvexen Abschnitt (13) umfasst, der zwischen dem ersten Verbindungsabschnitt (11) und dem zweiten Verbindungsabschnitt (12) angeschlossen ist; wobei der erste Verbindungsabschnitt (11) ein erstes Verbindungsloch umfasst und der erste Verbindungsabschnitt über das erste Verbindungsloch mit dem ersten Batteriemodul verbunden ist; und wobei der zweite Verbindungsabschnitt (12) ein zweites Verbindungsloch umfasst und der zweite Verbindungsabschnitt über das zweite Verbindungsloch mit dem zweiten Batteriemodul verbunden ist, wobei das erste Batteriemodul und das zweite Batteriemodul nebeneinander liegen;
wobei die Vorrichtung **dadurch gekennzeichnet ist, dass** sie umfasst:
eine Modusanalyseeinheit, die dazu konfiguriert ist, eine Modusanalyse an einem zuvor hergestellten Finite-Elemente-Gittermodell der Leistungsbatterie durchzuführen, um eine Richtung mit minimaler Steifigkeit im Finite-Elemente-Gittermodell der Leistungsbatterie zu finden, wobei das Finite-Elemente-Gittermodell der Leistungsbatterie ein Finite-Elemente-Modell ist, in dem reale Strukturen von einem Batteriepackgehäuse, Batteriemodulen, einer Hochspannungsbox und eines BMS widergespiegelt sind und sowohl die Masse der flexiblen Kupfersammelschiene als auch die Masse eines Kabelbaums der Leistungsbatterie in das Batteriemodul hinzugefügt werden;
eine Datenerfassungseinheit, die dazu konfiguriert ist, ein Signal eines Betriebszustands mit extremen mechanischen Stößen zu erhalten, wobei das Signal des Betriebszustands mit extremen mechanischen Stößen Daten entspricht, die vorliegen, wenn zwischen dem ersten Batteriemodul und dem zweiten Batteriemodul ein maximaler Abstand geschaffen wird;
eine Analyseeinheit für mechanische Stöße, die dazu konfiguriert ist, das Signal des Betriebszustands mit extremen mechanischen Stößen in der Richtung mit der minimalen Steifigkeit im Finite-Elemente-Gittermodell der Leistungsbatterie anzuwenden, um eine Analyse mechanischer Stöße durchzuführen, bei der der maximale Abstand zwischen dem ersten Batteriemodul und dem zweiten Batteriemodul erhalten wird; und
eine Gesamtlängenberechnungseinheit, die dazu konfiguriert ist, ein Anfangsabstand zwischen dem ersten Batteriemodul und dem zweiten Batteriemodul vom maximalen Abstand abzuziehen, das so erhaltene Ergebnis mit einem vorgegebenen Sicherheitsfaktor zu multiplizieren und dann ein Anfangsabstand zwischen den gegenüberliegenden Enden der flexiblen Kupfersammelschiene zu dem mit dem Sicherheitsfaktor multiplizierten Ergebnis zu addieren, sodass die Gesamtlänge der flexiblen Kupfersammelschiene erhalten wird, wobei der Wert des Sicherheitsfaktors aus einem Bereich von 1 bis 3 ausgewählt wird.

4. Vorrichtung nach Anspruch 3, **dadurch gekennzeichnet, dass** der Sicherheitsfaktor 2 beträgt.

## Revendications

1. Procédé de conception d'une barre omnibus flexible en cuivre d'une batterie d'alimentation, la barre omnibus flexible en cuivre comprenant une première partie de connexion (11), une seconde partie de connexion (12) et une partie convexe (13) connectée entre la première partie de connexion (11) et la seconde partie de connexion (12); dans lequel la première partie de connexion (11) comprend un premier trou de connexion, et la première partie de connexion est connectée au premier module de batterie par l'intermédiaire du premier trou de connexion ; et dans lequel la seconde partie de connexion (12) comprend un second trou de connexion, et la seconde partie de connexion est connectée au second module de batterie par l'intermédiaire du second trou de connexion, le premier module de batterie et le second module de batterie étant adjacents l'un à l'autre ;
le procédé étant **caractérisé en ce qu'**il comprend :
la réalisation d'une analyse de mode sur un modèle de grille d'éléments finis préalablement établi de la batterie d'alimentation pour trouver une direction avec une rigidité minimale dans le modèle de grille d'éléments finis de la batterie d'alimentation, le modèle de grille d'éléments finis de la batterie d'alimentation étant un modèle d'éléments finis dans lequel des structures réelles d'un boîtier de bloc-batterie, de modules de batterie, d'une boite haute tension et d'un BMS sont reflétées, et la masse de la barre omnibus flexible en cuivre et la masse d'un câblage de la batterie d'alimentation étant toutes deux ajoutées dans le module de batterie ;
l'obtention d'un signal d'une condition de fonctionnement de choc mécanique extrême, le signal de la condition de fonctionnement de choc mécanique extrême correspondant à des données présentées lorsqu'un espace maximal est créé entre le premier module de batterie et le second module de batterie ;
l'application du signal de la condition de fonctionnement de choc mécanique extrême dans la direction avec la rigidité minimale dans le modèle de grille d'éléments finis de la batterie d'alimentation pour réaliser une analyse de choc mécanique dans laquelle l'espace maximal entre le premier module de batterie et le second module de batterie est obtenu ; et
l'obtention de la longueur totale de la barre omnibus flexible en cuivre en soustrayant d'abord un espace initial entre le premier module de batterie et le second module de batterie de l'espace maximal, puis en multipliant le résultat ainsi obtenu par un facteur de sécurité prédéterminé, et ensuite en ajoutant un espace initial entre des extrémités opposées de la barre omnibus flexible en cuivre au résultat qui a été multiplié par le facteur de sécurité, la valeur du facteur de sécurité étant choisie dans une plage de 1 à 3.

2. Procédé de la revendication 1, **caractérisé en ce que** le facteur de sécurité est de 2.

3. Appareil de conception d'une barre omnibus flexible en cuivre d'une batterie d'alimentation, la barre omnibus flexible en cuivre comprenant une première partie de connexion (11), une seconde partie de connexion (12) et une partie convexe (13) connectée entre la première partie de connexion (11) et la seconde partie de connexion (12); dans lequel la première partie de connexion (11) comprend un premier trou de connexion, et la première partie de connexion est connectée au premier module de batterie par l'intermédiaire du premier trou de connexion ; et dans lequel la seconde partie de connexion (12) comprend un second trou de connexion, et la seconde partie de connexion est connectée au second module de batterie par l'intermédiaire du second trou de connexion, le premier module de batterie et le second module de batterie étant adjacents l'un à l'autre ;
l'appareil étant **caractérisé en ce qu'**il comprend :
une unité d'analyse de mode configurée pour réaliser une analyse de mode sur un modèle de grille d'éléments finis préalablement établi de la batterie d'alimentation afin de trouver une direction avec une rigidité minimale dans le modèle de grille d'éléments finis de la batterie d'alimentation, le modèle de grille d'éléments finis de la batterie d'alimentation étant un modèle d'éléments finis dans lequel des structures réelles d'un boîtier de bloc-batterie, de modules de batterie, d'une boite haute tension et d'un BMS sont reflétées, et la masse de la barre omnibus flexible en cuivre et la masse d'un câblage de la batterie d'alimentation étant toutes deux ajoutées dans le module de batterie ;
une unité d'acquisition de données configurée pour obtenir un signal d'une condition de fonctionnement de choc mécanique extrême, le signal de la condition de fonctionnement de choc mécanique extrême correspondant à des données présentées lorsqu'un espace maximal est créé entre le premier module de batterie et le second module de batterie ;
une unité d'analyse de choc mécanique configurée pour appliquer le signal de la condition de fonctionnement de choc mécanique extrême dans la direction avec la rigidité minimale dans le modèle de grille d'éléments finis de la batterie d'alimentation pour réaliser une analyse de choc mécanique dans laquelle l'espace maximal entre le premier module de batterie et le second module de batterie est obtenu ; et
une unité de calcul de longueur totale configurée pour soustraire un espace initial entre le premier module de batterie et le second module de batterie de l'espace maximal, pour multiplier le résultat ainsi obtenu par un facteur de sécurité prédéterminé, et ensuite pour ajouter un espace initial entre des extrémités opposées de la barre omnibus flexible en cuivre au résultat qui a été multiplié par le facteur de sécurité afin que la longueur totale de la barre omnibus flexible en cuivre soit obtenue, la valeur du facteur de sécurité étant choisie dans une plage de 1 à 3.

4. Appareil de la revendication 3, **caractérisé en ce que** le facteur de sécurité est de 2.
